# EUROPEAN PATENT APPLICATION

(11) **EP 2 846 469 A1**
(43) Date of publication of application: **11.03.2015**
(21) Application number: 13306240.6
(22) Date of filing: 10.09.2013
(51) Int. Cl.: H03M 13/37, H04L 1/16, H04L 1/18, H04L 1/00

(54) **Rateless encoding**

(71) Applicant: ALCATEL LUCENT, 92100 Boulogne-Billancourt (FR)
(72) Inventor: Razavi, Rouzbeh, Dublin, 15 (IE); Claussen, Holger, Dublin, 15 (IE)
(74) Representative: Leppard, Andrew John

(57) **Abstract**

A receiver method, a transmitter method, a receiver, a transmitter and computer program products are disclosed. The receiver method comprises: receiving from a transmitter a ratelessly-encoded data packet encoding at least one source data packet from a group of source data packets; and identifying whether a selected source data packet from the ratelessly-encoded data packet will be decodable and, if so, transmitting an indication to the transmitter to exclude the selected source data packet from being encoded in other ratelessly-encoded data packets. In this way, the receiver is able to identify source data packets which it expects to be able to decode and so can request that they be excluded in future, which reduces the buffer requirements at the transmitter since the excluded source data packets may be deleted from the buffer since they are no longer required and which improves the efficiency of the rateless encoding since those excluded source data packets are not transmitted again in subsequent ratelessly-encoded data packets. This causes the transmitter to select more appropriate source data packets which may be required by the receiver for decoding other data packets and results in improved decoding speed which leads to lower latency and jitter, as well as reduced buffer requirements.

## Description

### FIELD OF THE INVENTION

The present invention relates to a receiver method, a transmitter method, a receiver, a transmitter and computer program products.

### BACKGROUND

Communications networks exist for the transfer of data between nodes of a network. Communications links are provided between the nodes of the network over which the data between network nodes is transferred. Different protocols exist which define how the data is transferred between the network nodes over the communications links. Various different classifications of nodes exist which may be deployed. Although such networks enable the transfer of data between nodes, unexpected consequences can occur. Accordingly, it is desired to provide an improved technique for transferring data between nodes.

### SUMMARY

According to a first aspect, there is provided a receiver method, comprising: receiving from a transmitter a ratelessly-encoded data packet encoding at least one source data packet from a group of source data packets; and identifying whether a selected source data packet from the ratelessly-encoded data packet will be decodable and, if so, transmitting an indication to the transmitter to exclude the selected source data packet from being encoded in other ratelessly-encoded data packets.

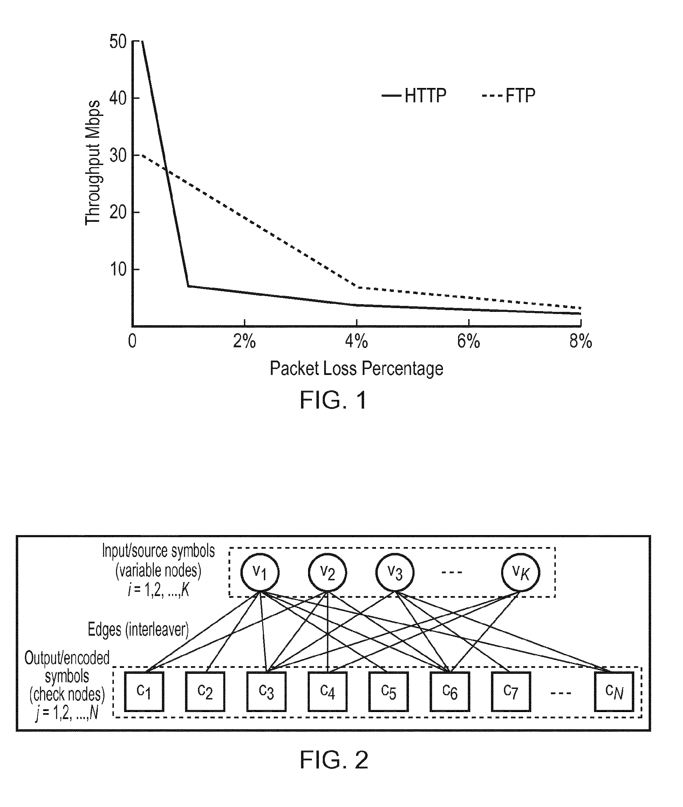

The first aspect recognises that latency is considered as a major concern when it comes to adoption of cloud-based services using networks. Additionally, lack of suitable quality of service (QoS) mechanisms and network underutilisation despite traffic demands results in delay in deployment of cloud-based services. The Transmission Control Protocol (TCP) is currently considered as the main transport protocol. According to research, TCP carries more than 89% of the total traffic world-wide. However, TCP's performance is very sensitive to packet losses and delayed packets. Specifically, the aggressive back-offbehaviour of TCP results in underutilisation of links and increased packet delay. A very recent study suggests a possible 16-fold throughput improvement in networks by modifying TCP behaviour. Figure 1 shows an example of TCP performance in terms of achievable throughput versus packet loss. As illustrated, the throughput drops significantly with small packets' drop rates (that are usual in most networks).

The increased latency as the result of TCP back-off behaviour can be particularly problematic when considering cloud-based services where service level agreement (SLA) violations may result in financial penalties for the cloud provider. Unfortunately, such excessive delays occur more frequently when there is congestion in the network and that's exactly when TCP effects appear most. In addition to congestion, with the significant increase of mobile data usage, wireless links are becoming integrated part of most end-to-end communications. Wireless channels normally result in higher packet drops and hence TCP is known to be very sub-optimal choice for wireless channels (accordingly protocols such as WAP have their own transport protocol, WTP).

Despite these negative sides, TCP is still recognised for its performance reliability. Any other alternative solution should assure reliability of packet delivery without significant bandwidth overheads. As it will be explained, the rateless code based transport protocol is an efficient way to assure reliability while minimising the latency. The end to end protocol has been implemented and measurements indicate that there is a 4-fold throughput improvement (over wired links) and up to 11-fold (over wireless links) when using this transport protocol instead of TCP. These significant improvement gains are in-line with the quantities observed by other very recent research reports.

In addition to the latency, security and, more specifically, data confidentiality is another major concern for wide deployment of many cloud services. As a by-product of the proposed transport control protocol, confidentiality of data when transmitted over untrusted links (for example, over a public network) can be guaranteed.

However, as will be explained, despite of significant performance superiority over TCP, the first aspect recognises that the rateless code based transport protocol suffers a number of issues including increased latency and decoding complexity as well as buffer requirements both at the transmitter and the receiver.

As explained above, although TCP is the most common transport protocol, it suffers from increased latency as a result of aggressive back-offs as well as bandwidth underutilisation. The User Datagram Protocol (UDP), on the other hand, is a transport protocol which does not provide any guarantee on the reliability of the packets' delivery process. Using traditional fixed rate error correction codes is inefficient to combat packet drops (whole packet erasures). Additionally, packet-level error correction codes results in trade-off of bandwidth and reliability and may result in unnecessary utilisation of bandwidth by Forward error correction (FEC) codes. Hybrid automatic repeat request (ARQ) techniques in general are more efficient but their performance significantly depends on optimality of the parameters and reliability of the feedback channels.

Rateless based transport is a very promising way to overcome many issues related to the existing transport protocols. However, the first aspect recognises that rateless code based data delivery solutions suffer a number of issues including increased packet latency as a result of batch formation and decoding as well as substantial buffer space requirement both at the transmitter and the receiver sides.

Accordingly, a method for a receiver is provided. The method may comprise the step of receiving a ratelessly-encoded data packet from a transmitter. The ratelessly-encoded data packet may encode at least one source data packet from a group of or batch of source data packets. The method may also comprise the step of identifying when a selected one of the source data packets encoded in the ratelessly-encoded data packet will be decodable. In other words, it is identified whether it is expected that a selected source data packet is likely to be decodable or that it can be decoded based on information available to the receiver. When it is determined that a selected source data packet will be decodable, then an indication is transmitted to the transmitter instructing the transmitter to exclude the selected source data packet from being encoded in other ratelessly-encoded data packets. In this way, the receiver is able to identify source data packets which it expects to be able to decode and so can request that they be excluded in future, which reduces the buffer requirements at the transmitter since the excluded source data packets may be deleted from the buffer since they are no longer required and which improves the efficiency of the rateless encoding since those excluded source data packets are not transmitted again in subsequent ratelessly-encoded data packets. This causes the transmitter to select more appropriate source data packets which may be required by the receiver for decoding other data packets and results in improved decoding speed which leads to lower latency and jitter, as well as reduced buffer requirements.

In one embodiment, the method comprises adding the indication of the selected source data packet to a first list of source data packets which are inessential to be encoded within other ratelessly-encoded data packets. Accordingly, an indication of the selected source data packet is added to a first list. The first list indicates those data packets which are not essential to be encoded again within other ratelessly-encoded data packets. Hence, this first list contains an indication of source data packets which are expected to be decodable.

In one embodiment, the method comprises adding indications of other source data packets within the ratelessly-encoded data packet to a second list of source data packets which are essential to be encoded within other ratelessly-encoded data packets. Accordingly, other source data packets within the ratelessly-encoded data packets are added to a second list. The second list indicates those source data packets which need to be encoded within other ratelessly-encoded data packets since they are not currently expected to be decodable. This ensures that the source data packets which still need to be continued to be included in the ratelessly-encoded data packets are identified.

In one embodiment, the method comprises adding indications of other source data packets within the ratelessly-encoded data packet which fail to be included within the first list to a second list of source data packets which are essential to be encoded within other ratelessly-encoded data packets. Accordingly, only those other source data packets within the ratelessly-encoded data packets which are not included in the first list are added to the second list. This ensures that source data packets which are already expected to be able to be decoded are not identified as still being essential.

In one embodiment, the step of identifying comprises identifying whether the selected source data packet from the ratelessly-encoded data packet is decodable by determining that an indication of the selected source data packet is omitted from the second list. Accordingly, when it is identified that the selected source data packet fails to be included or is not present in the second list then this means that other source data packets are not dependent on this source data packet for their decoding and so the selected source data packet may still be decodable using other ratelessly-encoded data packets which have either been received by the receiver or which will likely be received by the receiver subsequently. Hence, the selected source data packet may be identified as one which is decodable and an indication of that source data packet may be then added to the first list.

In one embodiment, the step of identifying comprises identifying whether the selected source data packet from the ratelessly-encoded data packet is decodable when it is determined that the selected source data packet fails to be encoded with any other source data packets within the ratelessly-encode data packet. Accordingly, so-called "degree one" data packets (those data packets which are not encoded with any other source data packets) are clearly decodable since they do not depend on the receipt of any other data packets and they may be then identified as being decodable. Again, these source data packets may be also added to the first list.

In one embodiment, the selected source data packet is selected randomly from the ratelessly-encoded data packet.

In one embodiment, the selected source data packet is selected randomly from source data packets within the ratelessly-encoded data packet which are omitted from the first list and the second list. Accordingly, any source data packets within the ratelessly-encoded data packet which are not included in either the first or the second list may be selected randomly.

In one embodiment, the method comprises attempting to at least partially decode received ratelessly-encoded data packets following receipt of each ratelessly-encoded data packet. Accordingly, rather than waiting until the whole group of ratelessly-encoded data packets have been received, instead partial or full decoding may be attempted after the receipt of each or every 'n'th ratelessly-encoded data packet. This enables the encoding to start earlier than would otherwise be possible in order to identify those source data packets which no longer need to be transmitted during the transmission of the batch.

In one embodiment, the method comprises removing an indication of any decoded source data packets from the second list. Accordingly, should a source packet be decoded, then this data packet is no longer essential.

In one embodiment, the method comprises adding an indication of any decoded source data packet to the first list. Accordingly, any decoded source data packet may be added to the list of inessential data packets, which no longer need to be included in any subsequently transmitted ratelessly-encoded data packet.

In one embodiment, the method comprises transmitting the indication to the transmitter of any decoded source data packet added to the first list. Accordingly, as decoded source data packets are added to the first list, an indication may be transmitted to the transmitter to exclude those data packets from being included in subsequently transmitted in ratelessly-encoded data packets.

According to a second aspect, there is provided a receiver, comprising: reception logic operable to receive from a transmitter a ratelessly-encoded data packet encoding at least one source data packet from a group of source data packets; and logic operable to identify whether a selected source data packet from the ratelessly-encoded data packet will be decodable and, if so, to transmit an indication to the transmitter to exclude the selected source data packet from being encoded in other ratelessly-encoded data packets.

In one embodiment, the logic is operable to add the indication of the selected source data packet to a first list of source data packets which are inessential to be encoded within other ratelessly-encoded data packets.

In one embodiment, the logic is operable to add indications of other source data packets within the ratelessly-encoded data packet to a second list of source data packets which are essential to be encoded within other ratelessly-encoded data packets.

In one embodiment, the logic is operable to add indications of other source data packets within the ratelessly-encoded data packet which fail to be included within the first list to a second list of source data packets which are essential to be encoded within other ratelessly-encoded data packets.

In one embodiment, the logic is operable to identify whether the selected source data packet from the ratelessly-encoded data packet is decodable by determining that an indication of the selected source data packet is omitted from the second list.

In one embodiment, the logic is operable to identify whether the selected source data packet from the ratelessly-encoded data packet is decodable by determining that the selected source data packet fails to be encoded with any other source data packets within the ratelessly-encode data packet.

In one embodiment, the logic is operable to select the selected source data packet randomly from the ratelessly-encoded data packet.

In one embodiment, the logic is operable to select the selected source data packet randomly from source data packets within the ratelessly-encoded data packet which are omitted from the first list and the second list.

In one embodiment, the logic is operable to attempt to at least partially decode received ratelessly-encoded data packets following receipt of each ratelessly-encoded data packet.

In one embodiment, the logic is operable to remove an indication of any decoded source data packets from the second list.

In one embodiment, the logic is operable to add an indication of any decoded source data packet to the first list.

In one embodiment, the logic is operable to transmit the indication to the transmitter of any decoded source data packet added to the first list.

According to a third aspect, there is provided a transmitter method, comprising: transmitting a ratelessly-encoded data packet encoding at least one source data packet from a group of source data packets; and receiving from a receiver an indication to exclude a selected source data packet from being encoded in other ratelessly-encoded data packets.

In one embodiment, the method comprises removing the selected source data packet from the group of source data packets. By removing the selected source data packet from the group of source data packets, data packets which are decodable by the receiver are not retransmitted and instead it is more likely that source data packets which are essential to the receiver to enable the receiver to decode data packets may be transmitted instead.

In one embodiment, the ratelessly-encoded data packet is generated using an output distribution function, the method comprising: adjusting the output distribution in response to changes in a size of the group of source data packets.

In one embodiment, the method comprises the step of commencing encoding the ratelessly-encoded data packet encoding at least one source data packet from the group of source data packets prior to every source data packet from the group being received by the transmitter. Accordingly, rather than waiting for the complete group of source data packets to be received by the transmitter, instead the encoding commences when a number or a proportion of the group has been received. This enables the transmission of the ratelessly-encoded data packets to occur earlier than would otherwise be possible.

According to a fourth aspect, there is provided a transmitter, comprising transmission logic operable to transmit a ratelessly-encoded data packet encoding at least one source data packet from a group of source data packets; and reception logic operable to receive from a receiver an indication to exclude a selected source data packet from being encoded in other ratelessly-encoded data packets.

In one embodiment, the transmission logic is operable to remove the selected source data packet from the group of source data packets.

In one embodiment, the transmission logic is operable generate the ratelessly-encoded data packet using an output distribution function and to adjust the output distribution in response to changes in a size of the group of source data packets.

In one embodiment, the transmission logic is operable commence encoding the ratelessly-encoded data packet encoding at least one source data packet from the group of source data packets prior to every source data packet from the group being received by the transmitter.

According to a fifth aspect, there is provided a computer program product operable, when executed on a computer, to perform the method steps of the first or the third aspects.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:
Figure 1 illustrates example TCP performance when packet loss is present;
Figure 2 shows a bipartite-graph-based description of an LT code showing the source symbols (variable nodes) and the LT-encoded symbols (check nodes). The symbols can be of an arbitrary size. For instance, c4 is calculated by the modulo-2 sum (XOR product) of v2 and vK in the specific example portrayed in this bipartite graph;
Figure 3 shows a comparison of TCP (with CWND=1 in this example) and a rateless coding transmission scheme;
Figure 4 shows a histogram of the actual number of rateless coded packets required to successfully decode 10,000 original packets. The upper figure shows the case where the average number of required packets is smaller but the variance is higher;
Figure 5 is a snapshot showing the performance comparison of a rateless code based transport and TCP for a wired network scenario;
Figure 6 is a flowchart showing the main processing steps for updating essential and inessential packets lists according to one embodiment;
Figure 7 illustrates the end-to-end packet delay over time when λ/η=0.9 and for a) embodiments and b) a conventional method;
Figure 8 shows a comparison of the average latency values between embodiments and conventional schemes a) without packet ordering requirement and b) with packet ordering requirement;
Figure 9 shows the average packet jitter for embodiments and conventional schemes;
Figure 10 shows an illustrative example showing buffer occupancy at the transmitter and the receiver sides;
Figure 11 shows a comparison of the average buffer occupancy between the proposed and the conventional schemes at a) transmitter and b) receiver sides;
Figure 12 illustrates the distribution of the number of packets required to decode 10,000 input packets using embodiments and the conventional method; and
Figure 13 illustrates the impact of increasing feedback interval on a) packets latency b) buffer occupancy.

### DESCRIPTION OF THE EMBODIMENTS

### Overview

Before discussing the embodiments in any more detail, first an overview will be provided. Embodiments recognize that in conventional rateless-encoding, the transmitter waits until the complete group or batch of source data packets have been received before commencing to encode those data packets and transmit them as ratelessly-encoded data packets to the receiver. Again, in a conventional approach, the receiver waits until a batch or group of ratelessly-encoded data packets have been received prior to being decoded by the receiver. This leads to longer latencies and high jitter, as well as high buffer requirements in the transmitter and the receiver. By commencing the encoding in the transmitter and the decoding in the receiver earlier than this and by identifying source data packet which the receiver will be able to decode, an indication of these decodable source data packets may be fed back to the transmitter. The transmitter may then cease to use those source data packets in the subsequent encoding being performed, which removes the redundancy that would otherwise be incurred by retransmitting those source data packets. Instead, this enables the transmitter to concentrate on source data packet which the receiver is not yet expecting to be able to decode. If the transmitter discards the decodable source data packets from its buffer then the buffer requirements of the transmitter can be reduced. Embodiments provide a simple technique for identifying and indicating source data packets which are expected to be decodable using two lists. A first or inessential list identifies those source data packets which are expected to be decodable by the receiver and which no longer require to be retransmitted. A second or essential list identifies those source data packets which cannot be identified as being inessential, since decoding of other source data packets depends upon these essential source data packets. As ratelessly-encoded data packets are received, it can be identified whether the packet should belong to the first or the second list, and source data packets which are subsequently decoded may be moved from the essential list to the inessential list as such decoding occurs. This enables the size of the group or batch of source data packets being encoded to reduce over time, thereby increasing the likelihood that a source data packet upon which the receiver depends to enable other data packets to be decoded is received.

In embodiments, the receiver compiles and maintains a list of inessential input or source data packets. If an input packet belongs to this list, it means that successful decoding of the batch is feasible even if the decoder does not receive any further encoded packets containing this input packet. For example, all of the received degree one packets can be considered as inessential since they do not need to be a part of any of the forthcoming or subsequently transmitted encoded packets. If this list is communicated back to the transmitter via a feedback channel, then the transmitter can discard inessential packets permanently from its buffer. This would have two implications: first, it will free up buffer space at the transmitter side and, secondly, it forces the encoder to concentrate on more relevant input packets which essentially reduces the coding overhead. Embodiments seek to compile the list of inessential input packets dynamically, on the fly and with minimal complexity.

### Overview of Rateless Codes

The rudimentary principles of the encoding and decoding techniques of rateless coding for transmission over erasure channels will now be explained in more detail. Luby transform (LT) codes are the first practical realization of rateless codes and these will be used to explain the principles ofrateless codes (whilst many other implementations/ variants are possible).

### Encoding Procedure

Assume a data message consisting of K input (source) symbols v = [v₁ v₂ ··· v_{K}], with each symbol containing an arbitrary number of bits. The terminology used often refers to the original data message v as a "file". Consider a hypothetical example of a data message containing four two-bit symbols given by the vector v =[00 10 11 01].

The LT-encoded symbols c = [cⱼ],2 j = 1, .., N, are simply the modulo-2 sum (i.e., the eXclusive OR (XOR)) of d_{c} distinct input symbols, chosen uniformly at random. The actual d_{c} value (defining the number of input or source symbols to be encoded for each LT-encoded symbol) is chosen from a pre-defined distribution f(d_{c}), which is also sometimes referred to as the output distribution. Assume now that the first d_{c}-value sampled from f(d_{c}) is 2. Consequently, two input symbols will be chosen at random from v. Assume that the two selected source symbols correspond to the first and second symbol in v. In THIS case, c₁ will be calculated as 00 ⊗ 10 = 10, where "⊗" denotes the XOR function.

The encoding algorithm proceeds in the same manner, each time selecting a d_{c}-value sampled pseudo-randomly from f(d_{c}) and then calculating the encoded symbol according to the XOR product of a dc-number ofpseudo-randomly selected source symbols. Sometimes the encoded symbols are referred to as the "LT-encoded packets" due to the natural applicability of LT codes to the communication channels.

The connection between the input and output symbols can also be diagrammatically represented by means of a bipartite graph, as shown in Figure 2. Using graph-related terminology, the input source symbol may be referred to as a variable node, whilst the LT-encoded symbol can be regarded as a check node. The number of edges emerging from each check node corresponds to the d_{c}-value sampled from f(d_{c}) and for this reason, d_{c} is sometimes referred to as the check degree.

### Decoding Procedure

Now consider an erasure channel, in which encoded symbols of c are erased during the ensuing transmission. Simplistically speaking, the task of the decoder is that of recovering the erased symbols from the unerased ones. The decoding process typically commences by locating a degree-one input symbol; i.e., a symbol that is not XOR-combined with any other. The decoder will then modulo-2 add the value of this symbol to all the LT-encoded symbols relying on it and then removes the corresponding modulo-2 connections, where each connection is represented by an edge on the associated bipartite graph (see Figure 2). The decoding procedure continues in an iterative manner, each time starting from a degree-one symbol or a newly decoded symbol.

### Rateless codes with Feedback

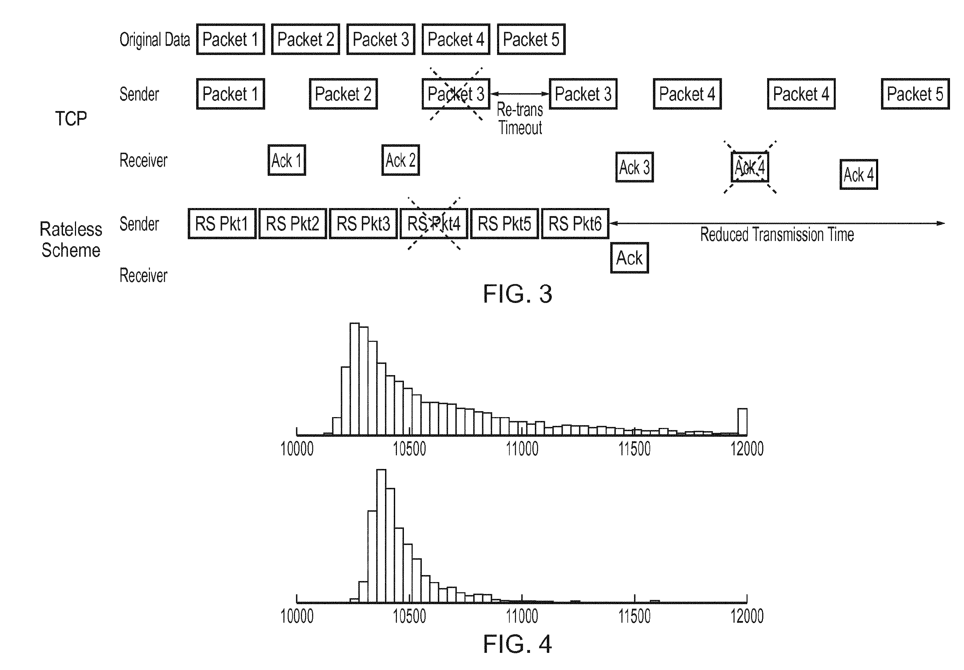

With an efficient implementation, any N original packets can be decoded using any N rateless codded packets with a high probability (in practice there is normally a marginal overhead). This is particularly important since it removes the requirement for the sender to retransmit a data packet that is dropped or received with uncorrectable errors (if error correction codes are in use). Instead, the sender can continue transmitting rateless coded packets until N packets are received. At this point the receiver can send a single acknowledgment packet to allow the sender to move on to the next group of packets. This can significantly improve the latency of the transmission compared to TCP (especially under congestion conditions when TCP congestion window is small). Figure 3 shows a schematic example comparing TCP and a transmission scheme based on rateless codes.

In this rateless codes scheme, the number ofpackets involved in each batch or group should be decided and communicated with the receiver. This rateless code based transport protocol will be very similar to the UDP, in that the transmitter will send data packets consequently. However, once enough correct packets are revived or decoded at the receiver side, it will send an acknowledgment and the transmitter can move on to the next batch or group. If the size of the batch or group is changed, it should be communicated with the receiver. It should be noted that all rateless coded packets contain mapping information in respect to the original packets. In Figure 3 for example, RS Pkt 1 might be result of the XOR operation of original packets 5 and 3. Since each batch of rateless coded packets covers a certain range of original packets, the receiver can easily tell each received packets belongs to which batch. Optionally, each packet can contain the batch ID.

In addition, due to the random nature of the rateless coding, it is possible that some coded packets are duplicated or some specific packets are missing in a given number of coded packets. Therefore, in practice some overhead may be required in order to assure successful decoding of rateless codded packets. Fortunately, this overhead is marginal (1-8 %). The actual overhead depends on the coding parameters. For example, with existing coding methods, it is possible to choose coding parameters such that the mean of the overhead is small with larger variance or instead using a strategy that requires higher overheads on average but with lower variance.

Figure 4 shows an example histogram of the actual number of rateless coded packets required to successfully decode 10,000 original packets for two different coding strategies.

### Performance of the rateless code based transport protocol

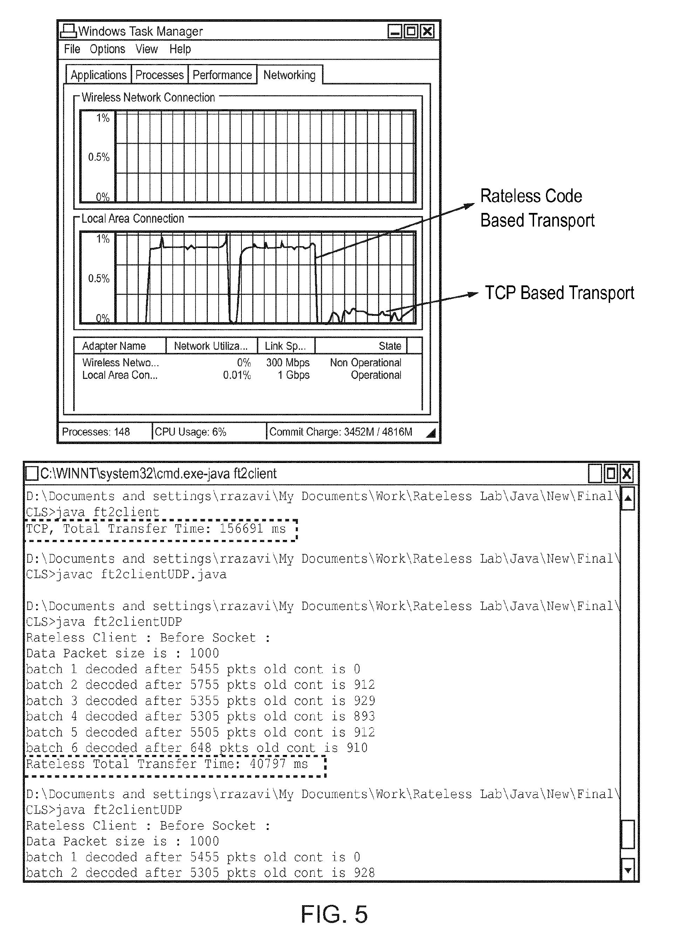

To examine the feasibility and to evaluate the performance gains of the above described transport protocol based on rateless codes, the full the end-to-end transport solution was implemented. Compared to the traditional TCP based transport, the new scheme provides a throughput gain of about 4-times when considering wired links and up to 11-times when the communication path consists of wireless links. Such enormous gains are very promising, making the adoption of this scheme to be likely in near future. Figure 5 shows some snapshots comparing the TCP based data transport with the new scheme for a wired communication scenario. In this example, a file transfer was used as a case study for comparison of throughput of the two schemes.

### Digital Fountain Codes

Initially proposed for one-to-many communication scenarios, Digital Fountain Codes (DCFs) are an example of rateless codes which are widely adopted in different areas of communication networks. Despite of their different flavours and varieties, their core objective is to generate a potentially limitless set of output symbols, each encoded as an independent combination of original input symbols. This allows constructing the original symbols of size k from any (1+ε)k encoded symbols where ε represents a small overhead. Fountain Codes are shown to be effective to address shortcoming of TCP. However, despite of their proven advantages, DFCs suffer from increased latency, decoding complexity and may require large buffer sizes. More specifically speaking, the transmitter needs to wait until all packets of the batch or group are available before starting coding and sending packets. In addition, rather than being progressively decoded, most of the packets are only decoded at the very end, after the required number of coded packets have been received. This has implications not only on the packet latency and jitter but also on buffer requirements both at the transmitter and receiver. Moreover, decoding complexity would also grow with the number of buffered packets at the decoder due to increased number of comparison operations needed. Embodiments provide practical data delivery scheme based on DFCs that seek to address these shortcomings.

### Example Operation

### Batch Size Variation

Rateless codes are normally more efficient when the input batch size, k, is increased. However, considering communication scenarios where input packets arrive one after each other, formation of a large batch may result in increased latency. The encoding and transmission of packets commences as soon as a minimum number of input packets are available. This minimum may be set as a threshold amount, which may be a specified number of packets or, more typically, a specified proportion of the batch size. While this may suggest an increased coding overhead, other mechanisms are used to mitigate this effect. As a result of this, the encoding parameters which define the robust soliton distribution from which the coding degree is selected must be dynamically adapted based on the current batch size. One major advantage of this scheme is that it facilitates progressive decoding of the input packets which ultimately results in reduced jitter and latency.

Given that the batch size is dynamically defined based on the available packets, to avoid tail of the latency distribution, a window of packets is defined where encoder does not consider any new input packet until it is assured that all input packets of the current window are successfully decoded at the receiver. The functionality of this window is in some sense similar to the batch size in traditional DFC-based data transport in a way that the encoder would only consider packets of the current batch when forming encoded packets.

### Packet Lists

The receiver compiles and maintains a list of inessential input packets. If an input packet belongs to this list, it means that successful decoding of the batch is feasible even if the decoder does not receive any further encoded packet including this input packet. For example, all of the received degree one packets can be considered as inessential since they do not need to be a part of any of the forthcoming or subsequent packets. If this list is communicated back to the transmitter via a feedback channel, the transmitter can discard inessential packets permanently from the buffer. This has two implications: first, it will free up buffer space at the transmitter side and, secondly, it forces the encoder to concentrate on more relevant input packets (those which the receiver is unable to decode) which essentially reduces the coding overhead.

The key issue is how to compile a list of inessential input packets dynamically, on-the-fly and with minimal complexity. Upon reception of any encoded packet comprising a set of input packets, the decoder is capable of decoding any of those input packets when the rest are known. Therefore, the receiver can select (typically randomly) one of the listed input packets and classify that as inessential based on the condition that the rest are in fact essential. The decoder then adds the selected packet into the inessential packets list and simultaneously appends any other input packets in the encoded packet into the essential packets list. When receiving the next encoded packet, again one of the included input packets is selected and will be considered as inessential if it does not already belong to the inessential or essential packets lists. If that packet is already included in any of those lists, another input packet is selected. If the decoder identifies an inessential input packet, the rest of the accompanying packets except those that are already listed as inessential will be added to the essential packets list. All degree one packets as well as any recently-decoded packets (which may be decoded as part of the iterative decoding performed following receipt of each encoded packet) are removed from the essential packets list (if they were part of it) and will be added to the inessential packets list.

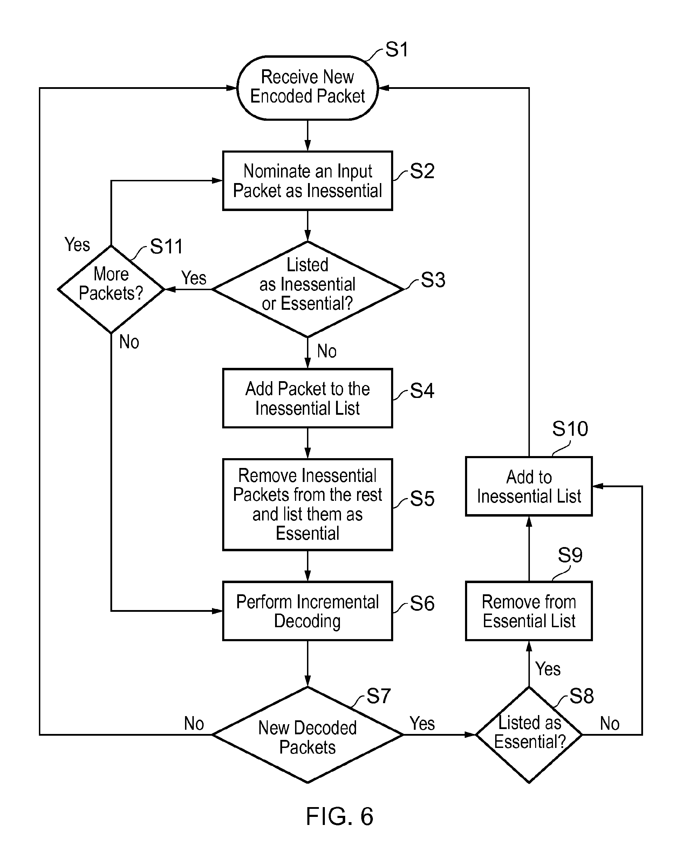

An example will now be described in more detail with reference to Figure 6 which shows the main processing steps of the receiver.

At step S1, a first encoded packet comprising input packets 1, 4 and 5 arrives.

At step S2, the decoder selects packet 4 as an inessential.

At step S3, the decoder determines that packet 4 is not listed as either inessential or essential.

At step S4, the decoder adds packet 4 to the inessential list and, at step S5, the decoder adds packets 1 and 5 to the essential packets list. This means that the decoder assumes it would not require to receive any further encoded packets containing input packet 4. However, that is only the case if the presence of packets 1 and 5 is guaranteed. The transmitter is informed at an appropriate point using feedback that packet 4 is no longer required to be used during encoding. The transmitter may then remove packet 4 from its buffer and may change its encoding parameters at an appropriate point to reflect the reduced size of the batch.

At step S6, the decoder attempts to decode the received packets.

At step S7, the decoder determines that no packets were decoded and so processing returns to step S1.

At step S1, the next received encoded packet includes input packets 5 and 2.

At step S2, packet 5 is selected but, at step S3, it is determined that it is listed in the essential list (packet 5 cannot be considered as inessential because it is required for decoding ofpacket 4 and hence is already listed as essential) and so processing proceeds to step S11 which determines that there are other packets present in the encoded packet.

At step S2, packet 2 is selected and, at step S3, it is determined that it is not listed in either list.

At step S4, input packet 2 is added to the list of inessential packets. The transmitter is informed at an appropriate point using feedback that packet 2 is no longer required to be used during encoding. The transmitter may then remove packet 2 from its buffer and may change its encoding parameters at an appropriate point to reflect the reduced size of the batch.

At step S5, there are no other packets to add to the essential list.

At step S6, the decoder attempts to decode the received packets.

At step S7, the decoder determines that no packets were decoded and so processing returns to step S1.

At step S1, the next received encoded packet includes packets 1, 4 and 2.

No changes will be made to the lists since no new inessential packet can be identified, nor can any packets be decoded and so processing returns to step S1.

At step S1, the next received encoded packet includes packet 1.

At step S2, packet 1 is selected and, at step S3, it is determined that it is listed in the essential list.

At step S11, it is determined that no more packets are present and so processing proceeds to step S6 where decoding recommences.

At step S7, the decoder determines that packet 1 was decoded and so processing proceeds to step S8.

At step S8, the decoder determines that packet 1 is included in the essential list and so processing proceeds to step S9 where it is removed from the essential list and then, at step S10, it is added to the inessential list. The transmitter is informed at an appropriate point using feedback that packet 1 is no longer required to be used during encoding. The transmitter may then remove packet 1 from its buffer and may change its encoding parameters at an appropriate point to reflect the reduced size of the batch. Processing then returns to step S1.

If the list of inessential input packets is periodically transmitted to the encoder via a lean feedback channel, the encoder can permanently remove those packets from its buffer and concentrate on the remaining packets for encoding forthcoming or subsequent packets. Moreover, if the encoder can confirm reception of this list by piggybacking an acknowledgement on top of on-going encoded data packets, the receiver can also remove those packets from its temporary decoding buffer when they are decoded. This is the case since the decoder would be assured that no further received encoded packet is dependent on inessential packets. This helps the decoder not only to reduce decoding buffer requirement but also mitigate decoding complexity as a result of reduced comparison operations.

### Performance Evaluation

Simulations were performed to quantify different performance aspects of the embodiments mentioned above. Packet arrival was modelled according to a Poisson process with the average arrival rate of λ. Packets were considered to be fixed in size and hence the maximum packet service rate, η, was constant. Moreover, packet service time, 1/η, was considered as a time unit. Note that η represents the upper bound of the packet service rate, while the actual rate is determined using the rate control algorithm described above. Unless otherwise stated, it is assumed that the receiver sends a feedback message to the transmitter upon reception of every 10 encoded packets.

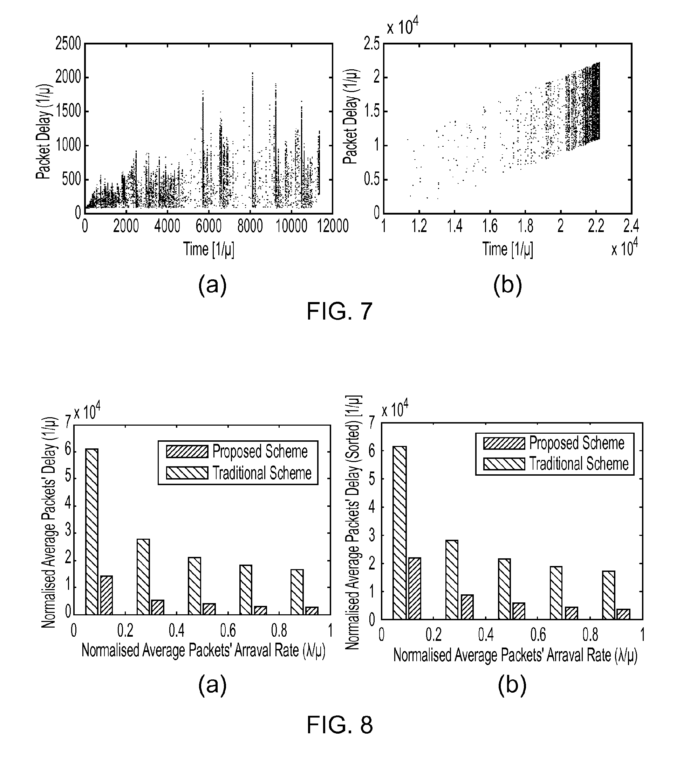

To compare the scheme of the embodiments against the traditional method, Figure 7 shows an illustrative example of delivering a window (batch) of packets where each point on the graph corresponds to an input packet being decoded at the time shown on the horizontal axis. The vertical axis represents the latency of the packet including the buffering time at the transmitter and receiver as well as transmission and propagation time. As shown, packets are progressively decoded in embodiments while, in the traditional scheme, most packets are decoded only at the very end. In embodiments, reception of some key encoded packets results in decoding of large number of packets which appears as vertical lines on the graph. As for the traditional scheme, the upper and lower bounds of the packet latency can be easily identified as two parallel lines. This is because the traditional scheme requires packets of the batch to be fully available before attempting to encode and transmit packets. Therefore, the lower bound of the latency corresponds to decoding of input packets that arrived last and correspondingly the upper bound refers to decoding of earlier input packets.

Figure 8 compares the average packet latency values of embodiments and traditional schemes for different normalized packet arrival rates. Expectedly, with the rate control algorithm in place, the latency is increased with lower packet arrival rates as it takes longer for all packets to arrive and the rate control algorithm assures that the packet departure rate is adjusted according to their arrival rate. Furthermore, in many applications, a packet has no use unless all proceeding packets are available. Subsequently, in calculating the latency, this fact was taken into account and the packet delay re-calculated by considering this requirement as shown in Figure 8b. Compared to Figure 8 a, it can be seen that the latency values are to some extent increased for embodiments but not significantly in case of the traditional scheme. This is because in this case, most packets are decoded at the very end of transmission anyway.

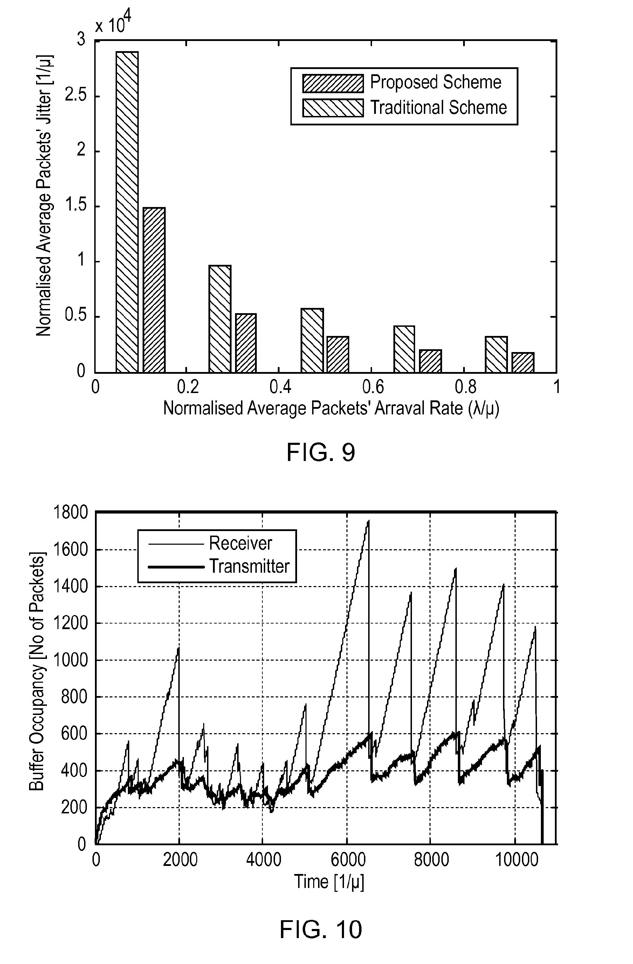

Not only average latency values, but also delay variation (i.e. packet jitter) is of particular interest in real-time applications. Figure 9 illustrates average jitter values (calculated as standard deviation of packet delay) for both schemes. As shown, the use of feedback results in progressive decoding of encoded packets which results in notable improvement of jitter in embodiments.

The use of the feedback channel additionally results in reduced buffer size requirements both at the transmitter and the receiver. Without that, the transmitter is required to keep all packets of a batch until the batch is fully decoded and the receiver additionally needs to retain all decoded packets as they might be used for decoding of forthcoming encoded packets. Figure 10 shows an illustrative example of transmitting packets for embodiments where the window size is set to 10,000 packets. Upon reception of some key packets, many other packets are decoded and are subsequently added to the inessential packets list. When the list is communicated back to the transmitter, it will remove them from the buffer and, by acknowledging the reception of the list, the receiver can also remove them from the decoder's buffer. The buffer occupancy is generally higher at the receiver side, since it stores also some inessential packets that are not decoded yet.

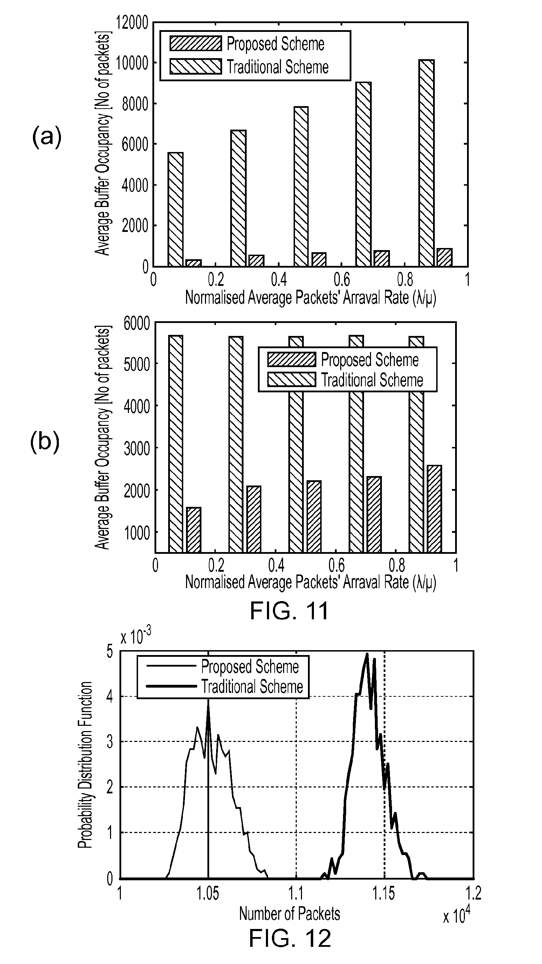

Figure 11 compares the average buffer occupancy of embodiments against the traditional scheme at both the transmitter (see Figure 11a) and the receiver (see Figure 11b) sides. The buffer fullness is recorded from the arrival of the first packet of the window (batch) until all packets are successfully decoded at the receiver. In both cases, the use of feedback channel results in significantly lower buffer occupation. As discussed earlier, improvements are much notable at the transmitter side. As for the traditional scheme, the buffer occupancy does not change with the packet arrival rate, as the transmitter does not start to send encoded packets until the batch is fully available.

Removing unusable decoded packets from the receiver's buffer would decrease the decoding complexity as a result of reduced number of comparisons being made. From the transmitter perspective, removal of inessential packets helps the encoder to focus on relevant input packets hence decreasing the coding overhead. Figure 12 compares the distribution of the number of packets required to fully decode 10,000 packets in both embodiments and traditional schemes. Based on the results shown, it is evident that using feedback channel not only mitigates the effect of using shorter batches that are dynamically changing in size, but indeed results in lower overall overhead of only 5.1% on average compared to the traditional scheme where the mean overhead quantity is just above 14%.

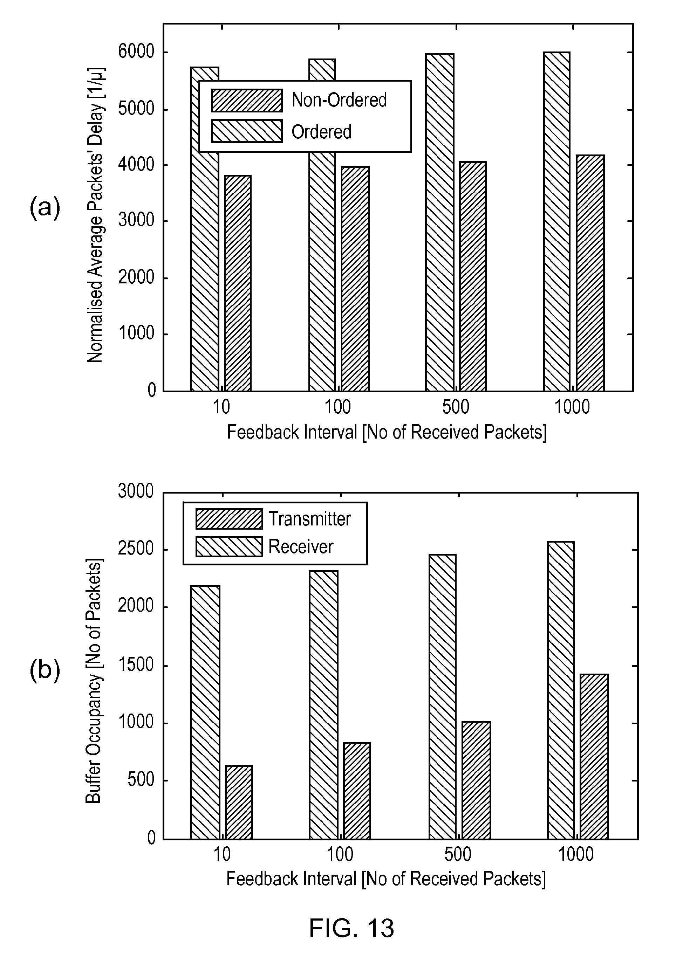

Moreover, to understand the impact of feedback frequency, Figure 13 illustrates how packet latency (considering both ordered and non-ordered cases) and buffer requirements at the transmitter and receiver sides are affected as a result of increasing feedback intervals. The results shown in Figure 13a and Figure 13b confirm that significant less periodic use of the feedback channel may not have a drastic impact on the overall performance. The impact on the transmitter's buffer fullness is to some extent notable while packet latency and receiver buffer fullness have not been changed to a great extent.

By exploring the feedback path, embodiments present a practical solution to overcome some of the major issues that are related to rateless codes especially when dealing with application with real-time or near real-time data delivery requirement. Compared to the traditional rateless code schemes, up to 77% reduction in average packet latency and up to 94% reduction in terms of required buffer space was observed. Additionally, the use of feedback channel improves decoding complexity and assists the encoder to concentrate on more relevant input packets resulting in reduction of the average overhead from 14% in traditional methods to 5.1% when using feedback channel.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/ or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A receiver method, comprising:
receiving from a transmitter a ratelessly-encoded data packet encoding at least one source data packet from a group of source data packets; and
identifying whether a selected source data packet from said ratelessly-encoded data packet will be decodable and, if so, transmitting an indication to said transmitter to exclude said selected source data packet from being encoded in other ratelessly-encoded data packets.

2. The method of claim 1, comprising: adding said indication of said selected source data packet to a first list of source data packets which are inessential to be encoded within other ratelessly-encoded data packets.

3. The method of claim 1 or 2, comprising: adding indications of other source data packets within said ratelessly-encoded data packet which fail to be included within said first list to a second list of source data packets which are essential to be encoded within other ratelessly-encoded data packets.

4. The method of claim 3, wherein said step of identifying comprises identifying whether said selected source data packet from said ratelessly-encoded data packet is decodable by determining that an indication of said selected source data packet is omitted from said second list.

5. The method of any preceding claim, wherein said step of identifying comprises identifying whether said selected source data packet from said ratelessly-encoded data packet is decodable when it is determined that said selected source data packet fails to be encoded with any other source data packets within said ratelessly-encode data packet.

6. The method of any one of claims 3 to 5, wherein said selected source data packet is selected randomly from source data packets within said ratelessly-encoded data packet which are omitted from said first list and said second list.

7. The method of any preceding claim, comprising: attempting to at least partially decode received ratelessly-encoded data packets following receipt of each ratelessly-encoded data packet.

8. The method of any one of claims 3 to 7, comprising: removing an indication of any decoded source data packets from said second list.

9. The method of any one of claims 3 to 8, comprising: adding an indication of any decoded source data packet to said first list.

10. The method of any one of claims 3 to 9, comprising: transmitting said indication to said transmitter of any decoded source data packet added to said first list.

11. A receiver, comprising:
reception logic operable to receive from a transmitter a ratelessly-encoded data packet encoding at least one source data packet from a group of source data packets; and
logic operable to identify whether a selected source data packet from said ratelessly-encoded data packet will be decodable and, if so, to transmit an indication to said transmitter to exclude said selected source data packet from being encoded in other ratelessly-encoded data packets.

12. A transmitter method, comprising:
transmitting a ratelessly-encoded data packet encoding at least one source data packet from a group of source data packets; and
receiving from a receiver an indication to exclude a selected source data packet from being encoded in other ratelessly-encoded data packets.

13. The method of claim 12, comprising: removing said selected source data packet from said group of source data packets.

14. A transmitter, comprising:
transmission logic operable to transmit a ratelessly-encoded data packet encoding at least one source data packet from a group of source data packets; and
reception logic operable to receive from a receiver an indication to exclude a selected source data packet from being encoded in other ratelessly-encoded data packets.

15. A computer program product operable, when executed on a computer, to perform the method steps of any one of claims 1 to 10, 12 and 13.

## Amended claims

### Amended claims in accordance with Rule 137(2) EPC.

1. A receiver method, comprising:
receiving (S1) from a transmitter a ratelessly-encoded data packet encoding at least one source data packet from a group of source data packets;
identifying (S2, S3) whether a selected source data packet from said ratelessly-encoded data packet will be decodable and, if so, transmitting an indication to said transmitter to exclude said selected source data packet from being encoded in other ratelessly-encoded data packets;
adding (S4) said indication of said selected source data packet to a first list of source data packets which are no longer required to be encoded within other ratelessly-encoded data packets; and
adding (S5) indications of other source data packets within said ratelessly-encoded data packet which fail to be included within said first list to a second list of source data packets which are required to be encoded within other ratelessly-encoded data packets.

2. The method of claim 1, wherein said step of identifying comprises identifying whether said selected source data packet from said ratelessly-encoded data packet is decodable by determining that an indication of said selected source data packet is omitted from said second list.

3. The method of any preceding claim, wherein said step of identifying comprises identifying whether said selected source data packet from said ratelessly-encoded data packet is decodable when it is determined that said selected source data packet fails to be encoded with any other source data packets within said ratelessly-encode data packet.

4. The method of any preceding claim, wherein said selected source data packet is selected randomly from source data packets within said ratelessly-encoded data packet which are omitted from said first list and said second list.

5. The method of any preceding claim, comprising: attempting (S6) to at least partially decode received ratelessly-encoded data packets following receipt of each ratelessly-encoded data packet.

6. The method of any preceding claim, comprising: removing (S9) an indication of any decoded source data packets from said second list.

7. The method of any preceding claim, comprising: adding (S10) an indication of any decoded source data packet to said first list.

8. The method of any preceding claim, comprising: transmitting said indication to said transmitter of any decoded source data packet added to said first list.

9. A receiver, comprising:
reception logic operable to receive from a transmitter a ratelessly-encoded data packet encoding at least one source data packet from a group of source data packets;
logic operable to identify whether a selected source data packet from said ratelessly-encoded data packet will be decodable and, if so, to transmit an indication to said transmitter to exclude said selected source data packet from being encoded in other ratelessly-encoded data packets, said logic being operable to add said indication of said selected source data packet to a first list of source data packets which are no longer required to be encoded within other ratelessly-encoded data packets and to add indications of other source data packets within said ratelessly-encoded data packet which fail to be included within said first list to a second list of source data packets which are required to be encoded within other ratelessly-encoded data packets.

10. A computer program product operable, when executed on a computer, to perform the method steps of any one of claims 1 to 8.
